# EUROPEAN PATENT APPLICATION

(11) **EP 1 793 426 A2**
(43) Date of publication of application: **06.06.2007**
(21) Application number: 06023940.7
(22) Date of filing: 17.11.2006
(51) Int. Cl.: H01L 29/78, H01L 21/336, H01L 23/48, H01L 29/417, H01L 29/06, H01L 29/08

(54) **Semiconductor device having a via hole and its manufacturing method**

(30) Priority: 30.11.2005 JP 2005345639
(71) Applicant: SHARP KABUSHIKI KAISHA, Osaka-shi, Osaka 545-8522 (JP)
(72) Inventor: Fukumi, Masayuki, Tenri-shi Nara 632-0078 (JP); Adan, Alberto O., Ikoma-shi Nara 630-0141 (JP)
(74) Representative: Müller - Hoffmann & Partner

(57) **Abstract**

A semiconductor device comprises at least one first electrode (11b) provided on the front surface of a semiconductor chip and electrically connected to at least one of electrodes that constitute a transistor, a second electrode (9) provided on the back surface of the semiconductor chip and electrically connected to one of the other electrodes, a via hole penetrating the semiconductor chip from the front surface to the back surface, and a through electrode (11a) a part of which is exposed on the front surface of the semiconductor chip electrically connected to the second electrode (9) through the via hole.

## Description

### BACKGROUND OF THE INVENTION

### 1. Field of the Invention

The present invention relates to a semiconductor device comprising at least one first electrode provided on the front surface of a semiconductor chip and electrically connected to at least one of electrodes that constitute a transistor, and a second electrode provided on the back surface of a semiconductor chip and electrically connected to one of the other electrodes, and its manufacturing method. More particularly it relates to a flip chip packaging technique of a power semiconductor device comprising a power MOSFET.

### 2. Description of the Related Art

The power MOSFET is a power device widely used in various kinds of power supply circuits and a car and the like, and improvement of its performance such as high-speed switching, lowering of on-resistance and the like have been demanded. The power MOSFET mainly comprises a trench type (vertical type) and a planar type (lateral type) and the trench type power MOSFET especially has a structure suitable for realizing high voltage resistance, large current intensity and low on-resistance, and it is an optimal element as a switching element.

In order to address the demand to high density chip wirings, attentions have been focused on flip chip packaging recently as an optimal packaging technique to implement function aggregation on a single chip that has been promoted by an electronics industry. With the flip chip method, a wire inductance can be considerably reduced and cost can be reduced because a die can be miniaturized. However, according to the flip chip packaging, since connection is made only from the front surface of the chip, the flip chip packaging cannot be used for a trench type power MOSFET or a planar type power MOSFET in which the source electrode is formed on the front surface of the chip and the drain electrode is formed on the back surface thereof, for example, because the drain region on the back surface cannot be connected to a pad.

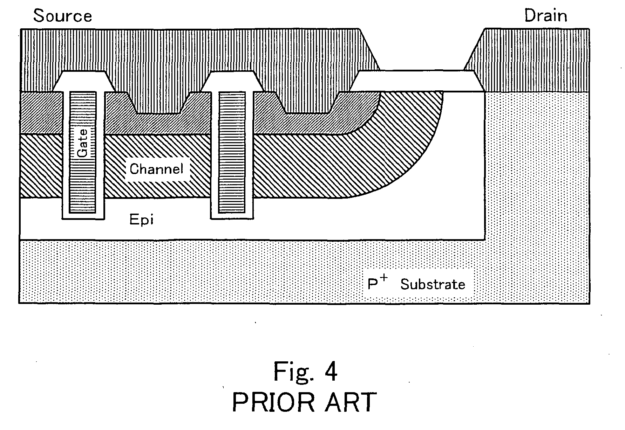

Meanwhile, as shown in Fig. 4, there is disclosed a trench type power MOSFET structure of a semiconductor device having the drain region on the back surface that can employ the flip chip packaging by connecting the drain region from the front surface (for example, Flip chip Power MOSFET : A New Wafer Scale Packaging Technique (ISPSD, June 2001) that is referred to as the document hereinafter). According to this semiconductor device, a diffusion layer that is the same type as the drain region is formed from the front surface to the drain region on the back surface so that the drain region on the back surface of the chip can be connected from the front surface, whereby the flip chip packaging can be employed.

However, according to the structure of the semiconductor device disclosed in the document, since the diffusion layer that is the same type as the drain region is formed so that it can be connected from the front surface through a substrate, the resistance of the drain region becomes high, which leads to the increase in on-resistance that is an important parameter in the power device. As a result, the characteristics of the element deteriorate.

### SUMMARY OF THE INVENTION

The present invention was made in view of the above problem and it is an object of the present invention to provide a semiconductor device in which a through electrode is formed from the front surface to the back surface of a chip and this through electrode is connected to a metal layer connected to a drain region formed on the back surface to minimize the increase in resistance of the drain region, whereby the flip chip packaging can be employed. In addition, it is an object of the present invention to provide a manufacturing method of the semiconductor device that can employ the flip chip packaging.

A semiconductor device according to the present invention to attain the above object comprises at least one first electrode provided on the front surface of a semiconductor chip and electrically connected to at least one of electrodes that constitute a transistor, and a second electrode provided on the back surface of the semiconductor chip and electrically connected to one of the other electrodes, and it is characterized by having a via hole penetrating the semiconductor chip from the front surface to the back surface and a through electrode a part of which is exposed on the front surface of the semiconductor chip electrically connected to the second electrode through the via hole, as the first characteristics.

The semiconductor device of the present invention having the above characteristics is further characterized in that the transistor is a trench type power MOSFET, at least one of the first electrodes is electrically connected to the source electrode of the transistor, and the through electrode is electrically connected to the drain electrode of the transistor through the second electrode.

The semiconductor device according to the present invention having the first characteristics is further characterized in that the transistor is a planar type power MOSFET, at least one of the first electrodes is electrically connected to the source electrode of the transistor, and the through electrode is electrically connected to the drain electrode of the transistor through the second electrode.

The semiconductor device according to the present invention having any one of the above characteristics is further characterized in that a part of the through electrode exposed on the front surface of the semiconductor chip and the first electrode are used as terminals for external connection when the semiconductor chip is packaged.

A manufacturing method of a semiconductor device according to the present invention to attain the above object is for manufacturing the semiconductor device according to the present invention having any one of the above characteristics and it is characterized by comprising forming the via hole so as to reach the second electrode from the front surface of a semiconductor substrate on which the transistor and the second electrode are formed and forming the through electrode by filling the via hole by a plating process.

The manufacturing method of the semiconductor device according to the present invention having the above characteristics is further characterized by comprising plating the whole front surface of the semiconductor substrate by the plating process and patterning the plating by etching so that the through electrode and the first electrode are patterned at the same time.

The manufacturing method of the semiconductor device according to the present invention having any one of the above characteristics further characterized by comprising depositing a seed metal film at least on the inner wall of the via hole before the plating process.

According to the semiconductor device in the present invention, since the through electrode that is electrically connected to the second electrode through the via hole that penetrates the semiconductor chip from the front surface to the back surface is provided, the flip chip packaging can be employed even in the semiconductor device in which the source electrode is formed on the front surface of the semiconductor chip and a drain electrode formed on the back surface thereof. Thus, as compared with the conventional packaging, a wired can be considerably shortened, a wiring inductance can be reduced, and the performance of an element such as switching characteristics can be improved, and furthermore, a power supply noise can be considerably reduced. In addition, since the flip chip packaging does not need an outer peripheral space in a bonding pad, the chip size can be miniaturized and costs can be reduced.

In addition, according to the manufacturing method of the semiconductor device in the present invention, the concrete manufacturing method of the above semiconductor device can be provided. As a result, the semiconductor device can employ the flip chip packaging even when the semiconductor device comprises the source electrode on the front surface of the semiconductor chip and the drain electrode on the back surface thereof, and a working effect of the semiconductor device described above can be provided.

### BRIEF DESCRIPTION OF THE DRAWINGS

Fig. 1 is a schematic sectional view showing a schematic constitution of a semiconductor device according to a first embodiment of the present invention;
Figs. 2A to 2D are sectional views showing the steps of a manufacturing method of the semiconductor device according to the first embodiment of the present invention;
Figs. 3A to 3D are sectional views showing the steps of a manufacturing method of the semiconductor device according to a second embodiment of the present invention;
Fig. 4 is a schematic sectional view showing a schematic constitution of a semiconductor device according to a conventional technique; and

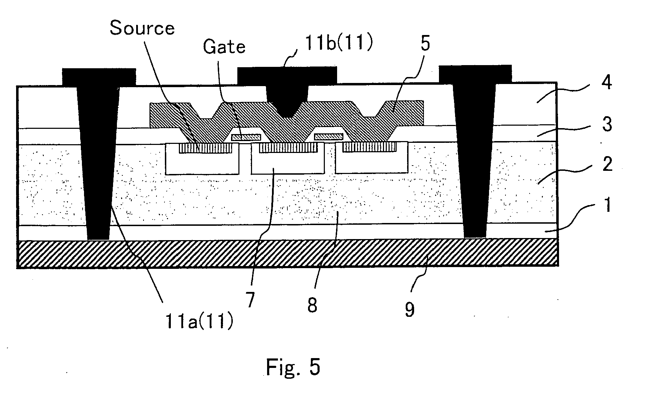

Fig. 5 is a schematic sectional view showing a schematic constitution of a semiconductor device according to another embodiment of the present invention.

### DETAILED DESCRIPTION OF THE INVENTION

Embodiments of a semiconductor device and its manufacturing method according to the present invention (referred to as the "device of the present invention" and "method of the present invention" occasionally) will be described with reference to the drawings hereinafter.

### (First embodiment)

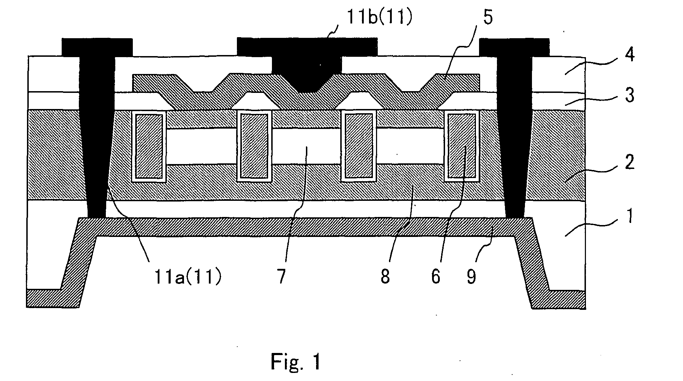

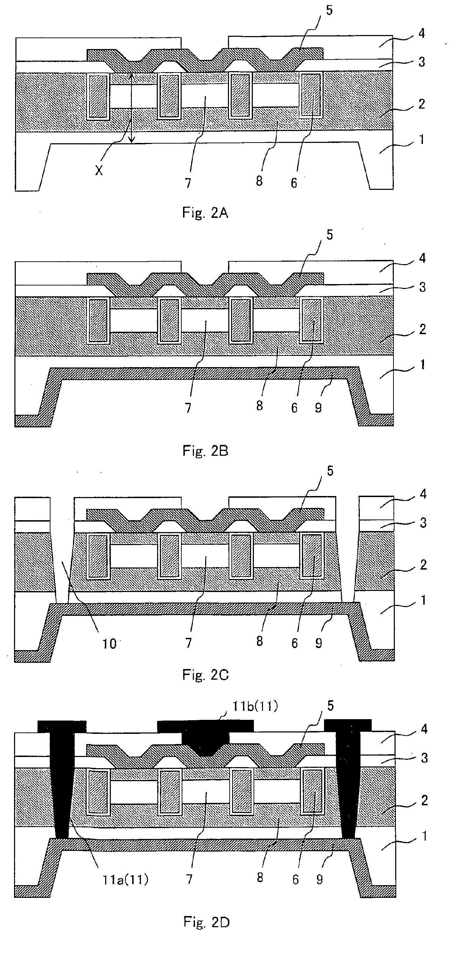

The device of the present invention and the method of the present invention according to a first embodiment will be described with reference to Fig. 1 and Figs. 2A to 2D. Here, Fig. 1 is a schematic sectional view showing the schematic constitution of the device of the present invention according to this embodiment.

A transistor used in this embodiment is a trench type power MOSFET and at least one first electrode 11b provided on the front surface of a silicon substrate 1 is electrically connected to the source electrode of the transistor through a metal wiring 5. In addition, a through electrode 11a is electrically connected to the drain electrode of the transistor through a second electrode (metal layer 9) provided on the back surface of the silicon substrate 1. Furthermore, the through electrode 11a is electrically connected to the second electrode (metal layer 9) through a via hole that penetrates a semiconductor chip from its front surface to its back surface. A part of the through electrode 11a exposed on the front surface of the semiconductor chip and the first electrode 11b are used as terminals for external connection when the semiconductor chip is packaged. In addition, a gate electrode (polysilicon layer 6) is electrically connected to one of the other first electrodes 11b on the front surface of the silicon substrate 1 although it is not shown.

The method of the present invention according to this embodiment will be described with reference to Figs. 2A to 2D hereinafter.

First, an epitaxial layer 2, an interlayer insulating film 3, a passivation film 4, the metal wiring 5, the polysilicon layer 6, a channel region 7 and a drift region 8 are formed on the silicon substrate 1 through conventional processes to form a trench type power MOSFET. Then, a resist is applied to the back surface of the silicon substrate 1 and aligned by a both-side aligner that can align the back surface based on an alignment mark on the front surface such that the back surface of the silicon substrate 1 in the region of the trench type power MOSFET is opened, and then patterned. Then, as shown in Fig. 2A, the silicon substrate 1 is etched away by a dry etching technique and the like to thin the thickness of the silicon substrate 1 to about 100µm in the device area indicated as X.

Then, as shown in Fig. 2B, the metal layer 9 is formed on the back surface of the silicon substrate 1 by sputtering. At this time, although the material of the metal layer 9 is not particularly limited, it is preferable that a metal material having low resistance is used to minimize the increase in on-resistance.

Then, as shown in Fig. 2C, a via hole 10 is formed so as to reach the metal layer 9 from the front surface of the silicon substrate 1 so that the metal layer 9 formed on the back surface of the silicon substrate 1 (the drain region of the trench type power MOSFET) can be connected from the front surface of the silicon substrate 1. More specifically, the via hole 10 is formed by applying a resist on the front surface of the silicon substrate 1 and patterning the via hole 10 having a diameter of about 20µmϕ using a conventional photo technique. Then, the interlayer insulating film 3, the epitaxial layer 2 and the silicon substrate 1 are etched away by dry etching, whereby the via hole 10 reaches the metal layer 9 sputtered on the back surface of the silicon substrate 1.

Then, as shown in Fig. 2D, the through electrode 11a is formed by filling the via hole 10 with a plating material by a plating process with gold (Au), nickel (Ni) and the like. Furthermore, here, before the plating process, a seed metal film is deposited at least on the inner wall of the via hole 10. More specifically, after a seed metal (metal having a two-layer structure of Au/Ti) as a seed metal film has been deposited on the inner wall of the via hole 10 by sputtering, the plating process is performed on the whole front surface of the silicon substrate 1 to form a plating 11 so that the via hole 10 is filled with the plating 11. As the plating material, gold (Au), nickel (Ni) or the like is used. Then, a resist is applied to the front surface of the silicon substrate 1 to pattern the front surface of the silicon substrate 1 so that a part other than the plating 11 that will be connected to a carrier at the time of flip chip packaging is opened, and the plating 11 and the seed metal film are etched away at the same time. Thus, the through electrode 11a is formed and the metal layer 9 formed on the back surface of the silicon substrate 1 can be connected from the front surface of the silicon substrate 1.

### (Second embodiment)

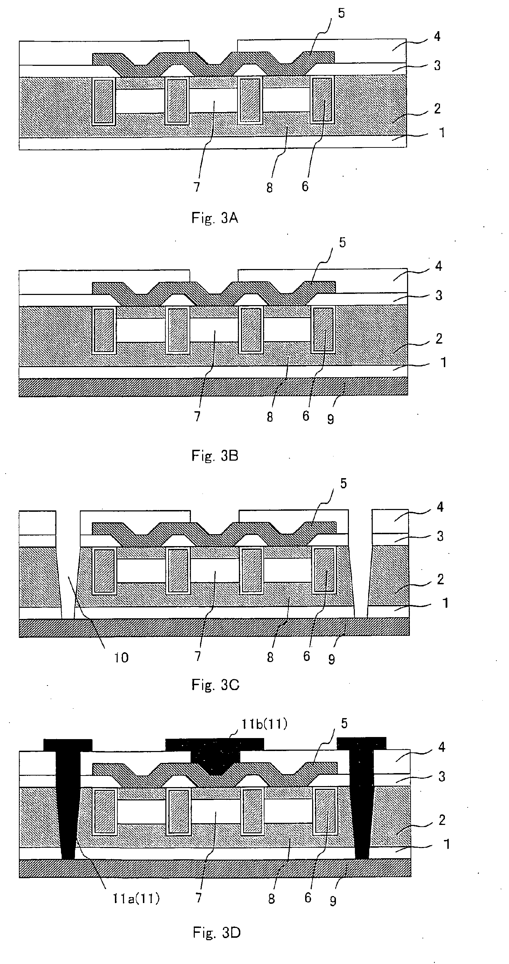

The method of the present invention according to a second embodiment will be described with reference to Figs. 3A to 3D. In this embodiment, a description will be made, taking the trench type power MOSFET as an example similar to the first embodiment.

First, the trench type power MOSFET is formed by the conventional processes similar to the first embodiment. Then, according to this embodiment, as shown in Fig. 3A, the thickness of a silicon substrate 1 is thinned to about 100µm by grinding the back surface.

Then, as shown in Fig. 3B, a metal layer 9 is formed on the back surface of the silicon substrate 1 by sputtering. In this embodiment, although the material of the metal layer 9 is not particularly limited similar to the first embodiment, a metal material having low resistance is used to minimize the increase in on-resistance.

Then, as shown in Fig. 3C, a via hole 10 is formed so as to reach the metal layer 9 from the front surface of the silicon substrate 1 so that the metal layer 9 formed on the back surface of the silicon substrate 1 (the drain region of the trench type power MOSFET) can be connected from the front surface of the silicon substrate 1. More specifically, the via hole 10 is formed by applying a resist on the front surface of the silicon substrate 1 and patterning the via hole 10 having a diameter of about 20µmϕ using a conventional photo technique similar to the embodiment 1. Then, the interlayer insulating film 3, the epitaxial layer 2 and the silicon substrate 1 are etched away by dry etching, whereby the via hole 10 reaches the metal layer 9 sputtered on the back surface of the silicon substrate 1.

Then, as shown in Fig. 3D, after a seed metal (Au/Ti) as a seed metal film has been deposited on the inner wall of the via hole 10 by sputtering, the via hole 10 is filled with a plating material and the plating material is deposited on the whole front surface of the silicon substrate 1 by the plating process with gold (Au), nickel (Ni) and the like. As the plating material, gold (Au), nickel (Ni) or the like is used similar to the first embodiment. Then, a resist is applied to the front surface of the silicon substrate 1 to pattern the front surface of the silicon substrate 1 so that a part other than the plating 11 that will be connected to a carrier at the time of flip chip packaging is opened, and the plating 11 and the seed metal film are etched away at the same time. Thus, the through electrode 11a is formed and the metal layer 9 formed on the back surface of the silicon substrate 1 can be connected from the front surface of the silicon substrate 1.

Next, another embodiment of the device of the present invention and the method of the present invention will be described.

Although the trench type power MOSFET has been illustrated in the above embodiments, the device of the present invention and the method of the present invention may be applied to a semiconductor device in which a transistor is a planar type power MOSFET. Furthermore, the device of the present invention and the method of the present invention may be applied to an insulated gate type bipolar transistor (IGBT), for example, other than the power MOSFET.

## Claims

1. A semiconductor device comprising:
at least one first electrode provided on the front surface of a semiconductor chip and electrically connected to at least one of electrodes that constitute a transistor, and a second electrode provided on the back surface of the semiconductor chip and electrically connected to one of the other electrodes;
a via hole penetrating the semiconductor chip from the front surface to the back surface; and
a through electrode a part of which is exposed on the front surface of the semiconductor chip electrically connected to the second electrode through the via hole.

2. The semiconductor device according to claim 1, wherein
the transistor is a trench type power MOSFET,
at least one of the first electrodes is electrically connected to the source electrode of the transistor, and
the through electrode is electrically connected to the drain electrode of the transistor through the second electrode.

3. The semiconductor device according to claim 1, wherein
the transistor is a planar type power MOSFET,
at least one of the first electrodes is electrically connected to the source electrode of the transistor, and
the through electrode is electrically connected to the drain electrode of the transistor through the second electrode.

4. A method for manufacturing the semiconductor device according to claim 1 comprising:
forming the via hole so as to reach the second electrode from the front surface of a semiconductor substrate on which the transistor and the second electrode are formed; and
forming the through electrode by filling the via hole by a plating process.

5. The method according to claim 4 further comprising
plating the whole front surface of the semiconductor substrate by the plating process and patterning the plating by etching so that the through electrode and the first electrode are patterned at the same time.

6. The method according to claims 4 or 5 further comprising
depositing a seed metal film at least on an inner wall of the via hole before the plating process.

7. The method according to any one of claims 4 to 6 further comprising
using a part of the through electrode exposed on the front surface of the semiconductor chip and the first electrode as terminals for external connection when the semiconductor chip is packaged.
